# EUROPÄISCHE PATENTANMELDUNG

(11) **EP 3 185 020 A1**
(43) Veröffentlichungstag der Anmeldung: **28.06.2017**
(21) Anmeldenummer: 15201852.9
(22) Anmeldetag: 22.12.2015
(51) Int. Cl.: G01R 19/00, G01R 15/09, G01R 19/32

(54) **VORRICHTUNG UND VERFAHREN ZUR MESSUNG VON STROM**

(71) Anmelder: Siemens Aktiengesellschaft, 80333 München (DE)
(72) Erfinder: Finkenzeller, Michael, 80687 München (DE); Schulz, Martin, 80689 München (DE)

(57) **Zusammenfassung**

Es wird eine Vorrichtung (1) zur Messung von Strom angegeben, aufweisend einen Feldeffekttransistor (10) mit einer maximalen Sperrspannung von 100 V, der zwei Knotenpunkte (15, 16) aufweist zur seriellen Einbindung in einen Leiter (2), der den zu messenden Strom führt, wobei einer (15) der Knotenpunkte mit dem Drain-Kontakt und ein weiterer der Knotenpunkte (16) mit dem Source-Kontakt des Feldeffekttransistors (10) verbunden ist, eine parallel zum Feldeffekttransistor (10) angeordnete Einrichtung (12) zur Messung der am Feldeffekttransistor (10) zwischen den Knotenpunkten (15, 16) abfallenden Spannung und eine Steuereinrichtung (11) zur Ansteuerung des Gate-Kontakts des Feldeffekttransistors (10) und zur Wandlung des Signals der Einrichtung zur Messung der Spannung in einen Wert für den durch den Feldeffekttransistor (10) fließenden Strom.

## Beschreibung

Die Erfindung betrifft eine Vorrichtung und ein Verfahren zur Messung von Strom.

Eine bekannte Möglichkeit der Strommessung arbeitet mit einem in Serie zum Strompfad geschalteten elektrischen Widerstand, dem sogenannten Shunt-Widerstand. Der in Serie geschaltete Widerstand führt zu einer ständig vorhandenen Verlustleistung, wobei die Abführung der Wärme bei großen Verlustleistungen, also großen Strömen zu zusätzlichem baulichen Aufwand führt.

Ein anderer Ansatz ist die Erfassung des Stroms durch Ermittlung des daraus resultierenden Magnetfeldes. Es gibt zu diesem Ansatz unterschiedliche Verfahren, wie z.B. Kompensations-Stromwandler mit Hallsonde oder magnetoresistive Sensoren als integrierte Schaltkreise. Nachteil dieser Verfahren ist die im Vergleich zur Messung mit einem Shunt-Widerstand meist höhere Komplexität, die sich üblicherweise in höheren Kosten niederschlägt.

Aus R.Pajer etal, "MOS-FET as a Current Sensor in Power Electronics Converters", Sensors 2015, 15, 18061-18079 ist eine Messung des Stroms bekannt, bei dem in einer Halbbrücke mit selbstsperrenden MOSFETs, die einen elektrischen Wandler wie beispielsweise einen Hochsetzsteller bilden, die Source-Drain-Spannung über einem der MOSFETs ausgewertet wird. Nachteilig ist dabei, dass die Genauigkeit der Messung durch die Schaltvorgänge im MOSFET, die mit der Funktion als Steller zusammenhängen, verringert wird.

Es ist Aufgabe der vorliegenden Erfindung, eine Vorrichtung und ein Verfahren zur Messung von Strom anzugeben, mit denen der eingangs genannte Nachteil verringert wird.

Diese Aufgabe wird durch eine Vorrichtung mit den Merkmalen von Anspruch 1 gelöst. Eine weitere Lösung besteht in einem Verfahren mit den Merkmalen von Anspruch 12.

Die erfindungsgemäße Vorrichtung zur Messung von Strom umfasst einen Feldeffekttransistor, der eine maximale Sperrspannung von höchstens 100 V und zwei Knotenpunkte aufweist zur seriellen Einbindung in einen Leiter, der den zu messenden Strom führt. Dabei ist einer der Knotenpunkte mit dem Drain-Kontakt und ein weiterer der Knotenpunkte mit dem Source-Kontakt des Feldeffekttransistors verbunden.

Die Vorrichtung umfasst weiterhin eine parallel zum Feldeffekttransistor angeordnete Einrichtung zur Messung der am Feldeffekttransistor zwischen den Knotenpunkten abfallenden Spannung und eine Steuereinrichtung zur Ansteuerung des Gate-Kontakts des Feldeffekttransistors und zur Wandlung des Signals der Einrichtung zur Messung der Spannung in einen Wert für den durch den Feldeffekttransistor fließenden Strom.

Bei dem erfindungsgemäßen Verfahren zur Messung von Strom wird ein Feldeffekttransistor, der als selbstleitender Feldeffekttransistor gestaltet ist, seriell mit dem Drain- und Source-Kontakt in einen Leiter, der den zu messenden Strom führt, eingebunden, die am Feldeffekttransistor zwischen den Anschlusspunkten an den Leiter abfallende Spannung ermittelt und die ermittelte abfallende Spannung in einen Wert für den durch den Feldeffekttransistor fließenden Strom gewandelt wird.

Für die Erfindung wurde erkannt, dass die Verwendung eines selbstleitenden Feldeffekttransistors für die Messung des Stroms vorteilhaft ist, da dadurch die Verlustleitung, die durch die Vorrichtung verursacht wird und abgeführt werden muss, minimiert wird. Vorteilhaft wird dabei ein Feldeffekttransistor verwendet, was zusammen mit der selbstleitenden Eigenschaft zur Folge hat, dass bevorzugt ein dedizierter Feldeffekttransistor verwendet wird, d.h. einer, der nur für die Strommessung verwendet wird, nicht jedoch für anderweitige Schaltvorgänge.

Gleichzeitig kann jederzeit eine Messung durchgeführt werden, indem der Gatekontakt des Feldeffekttransistors mit einer Steuerspannung beaufschlagt wird und somit sein Widerstand erhöht wird. Zu Zeiten, in denen keine Strommessung stattfindet, schaltet die Steuerschaltung den Gatekontakt des Feldeffekttransistors bevorzugt spannungslos.

Der Feldeffekttransistor kann eine maximale Sperrspannung von 30 V aufweisen.

Vorteilhaft kann der Feldeffekttransistor ein selbstleitender Feldeffekttransistor sein. In diesem Fall ist ein geringer Widerstand gewährleistet, wenn keine spezielle Ansteuerung des Feldeffekttransistors erfolgt.

Besonders vorteilhaft ist es, wenn die Steuereinrichtung ausgestaltet ist, bei der Strommessung zu ermitteln, ob die von der Einrichtung zur Messung der Spannung ermittelte Spannung einen Schwellwert unterschreitet und in diesem Fall anstelle der Steuerspannung eine gegenüber der Steuerspannung erhöhte zweite Steuerspannung an den Gatekontakt anzulegen.

Dabei ist es auch möglich, mehrere Schwellwerte und mehrere mit den Schwellwerten verbundene zweite Steuerspannungen zu verwenden, so dass eine kontinuierlichere Anpassung des Widerstands, den der Feldeffekttransistor bietet, an den fließenden Strom stattfinden kann.

Vorteilhaft wird hierdurch ein dynamisch veränderbarer Messwiderstand geschaffen. Dadurch kann das Messsignal in Form der ermittelten Spannung für sehr unterschiedliche Ströme stets im gesamten Messbereich gehalten werden. Dies stellt weiterhin einen optimalen Signal-Rauschabstand sicher. Beide Maßnahmen stellen eine genaue Auswertung sicher.

In einer vorteilhaften Ausgestaltung ist eine Temperaturmesseinrichtung zur Bestimmung der Temperatur des Feldeffekttransistors vorhanden, wobei die Steuereinrichtung so ausgestaltet ist, dass bei der Wandlung des Signals die Temperatur als Eingangswert berücksichtigt ist. Es wird also mit anderen Worten eine Kompensation des Temperatureinflusses auf das Kennlinienfeld des Feldeffekttransistors vorgenommen, was die Messgenauigkeit deutlich verbessert.

In einer Ausgestaltung wird ein elektrischer Widerstand parallel zum Feldeffekttransistor geschaltet. Dadurch wird der Messbereich statisch verschoben. Dadurch wird vorteilhaft der Messbereich bzw. der elektrische Widerstand eingestellt.

Die Wandlung des ermittelten Spannungssignals in einen Wert für den fließenden Strom findet dabei bevorzugt anhand eines gespeicherten Kennlinienfeldes statt.

In einer Anwendung mit hohen Strömen ist es vorteilhaft, wenn bei der Strommessung ein Pulsbetrieb verwendet wird. Dabei wird zum Zeitpunkt der Messung ein höherer Widerstand als bei Zeitpunkten dazwischen eingestellt. Dadurch wird vorteilhaft die auftretende Verlustleistung im Sensor drastisch reduziert.

Weitere Vorteile und Einzelheiten der Erfindung gehen aus den Ausführungsbeispielen hervor, die anhand der Figuren erläutert werden. Dabei zeigen
- Figur 1: eine IGBT-Halbbrücke als Teil eines elektrischen Wandlers mit einer Strommesseinrichtung,
- Figur 2: die Strommesseinrichtung im Detail,

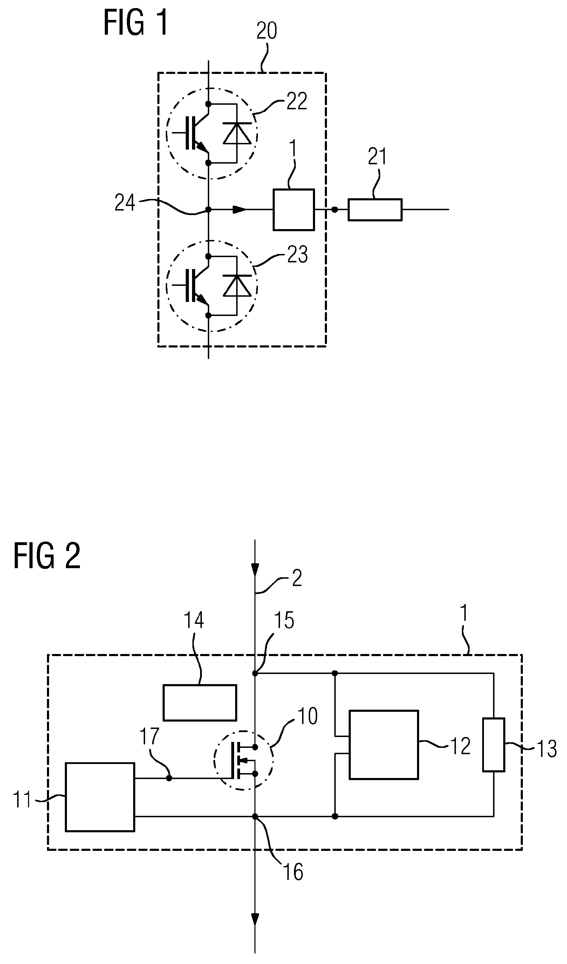

Figur 1 zeigt einen Ausschnitt aus einem elektrischen Wandler 20 in Form einer Halbbrücke mit zwei seriell geschalteten IGBTs 22, 23. Bei dem Wandler kann es sich beispielsweise um ein Netzteil oder einen Antriebsumrichter handeln. Als Beispiel kann diese Brücke zwischen zwei Potentialpunkte geschaltet sein, bei denen regelmäßig Spannungswerte im Bereich von kV auftreten und geschaltet werden. Die IGBTs 22, 23 müssen daher ausgewählt sein, eine Spannung von beispielsweise 1200 V sperren zu können.

Der Laststrompfad führt hier vom Knoten 24 zwischen den IGBTs 22, 23 zu einer Last 21. Seriell in diesen Laststrompfad geschaltet ist eine Messeinrichtung 1 zur Strommessung, die in Figur 2 detaillierter dargestellt ist.

Die Messeinrichtung 1 zur Strommessung wird mit einem ersten und zweiten Knotenpunkt 15, 16 seriell in den Strompfad, der über die Leitung 2 führt, eingebunden. Zwischen den ersten und zweiten Knotenpunkt 15, 16 ist ein Feldeffekttransistor 10 in Form eines selbstleitenden n-Kanal-Feldeffekttransistors geschaltet. Der erste Knotenpunkt 15 ist dabei mit dem Drain-Anschluss des Feldeffekttransistors 10 verbunden und der Source-Anschluss mit dem zweiten Knotenpunkt 16. Anstelle eines n-Kanal-Feldeffekttransistors kann auch ein p-Kanal-Feldeffekttransistor verwendet werden.

Aufgrund der niedrigen Sperrspannung des Feldeffekttransistors ist dieser vorteilhaft sehr niederohmig und bewirkt daher nur geringe Verluste, die als Abwärme abgeführt werden müssen. Über eine einstellbare Spannung am Gatekontakt des Feldeffekttransistors kann dessen Durchlasswiderstand für die Strommessung eingestellt/verändert werden.

Parallel zum Feldeffekttransistor 10, d.h. ebenfalls zwischen den ersten und zweiten Knotenpunkt 15, 16 geschaltet ist eine Anordnung 12 zur Spannungsmessung. Diese nimmt die Drain-Source-Spannung über den Feldeffekttransistor 10 auf und gibt sie an eine nicht gezeigte Steuerschaltung weiter.

Ebenfalls parallel zum Feldeffekttransistor 10, d.h. ebenfalls zwischen den ersten und zweiten Knotenpunkt 15, 16 geschaltet ist weiterhin ein Widerstand 13. Der Widerstand 13 senkt durch die parallele Beschaltung zum Feldeffekttransistor 10 den Gesamtwiderstand der Messeinrichtung 1 ab und verschiebt bei einer Messung, bei der der elektrische Widerstand des Feldeffekttransistors 10 in eine ähnliche Größenordnung gebracht wird, den Messbereich der Messeinrichtung 1. Der Widerstand 13 stellt eine optionale Anpassung der Messeinrichtung 1 dar und kann auch weggelassen werden.

Der Gate-Anschluss 17 des Feldeffekttransistors 10 sowie sein Source-Anschluss oder der zweite Knotenpunkt 16 sind weiterhin mit einer Gatetreiberschaltung 11 verbunden, die von der Steuerschaltung gesteuert wird. Die Gatetreiberschaltung 17 versorgt das Gate mit einer Ansteuerspannung, wenn eine Strommessung durchgeführt werden soll.

Eine weitere optionale Komponente ist eine Temperaturmesseinrichtung 14, die die Temperatur des Kleinsignaltransistors 10 bestimmt und an die Steuerschaltung weitergibt.

Die Steuerschaltung ihrerseits nimmt die Messwerte der Anordnung 12 zur Spannungsmessung sowie optional der Temperaturmesseinrichtung 14 auf und bestimmt daraus sowie aus der anliegenden Gatespannung einen Wert für die durch den Kleinsignaltransistor 10 fließenden Strom. eine Möglichkeit dafür ist, es ein diskretisiertes Kennlinienfeld in einem Speicher der Steuerschaltung zu hinterlegen und den Wert für den Stromfluss durch Interpolation aus dem Kennlinienfeld zu ermitteln.

Die Messeinrichtung 1 verwendet für die Strommessung einen eigens vorgesehenen, d.h. dedizierten, und seriell im Strompfad angeordneten Transistor. Dadurch wird erreicht, dass unabhängig von der Lage des Potentials relativ zu einem Erdpotential keine hohen Spannungsabfälle vom Transistor sperrbar sein müssen und somit ein Feldeffekttransistor mit geringer Sperrspannung zum Einsatz kommen kann, der ausgelegt ist für Spannungsabfälle < 30 V. Weiterhin müssen keine Schaltvorgänge des Transistors, die durch eine sonstige Aufgabe des Transistors anfallen, bei der Messung berücksichtigt werden. Temperatureinflüsse durch anderweitige Schaltvorgänge fallen ebenfalls nicht an. Besonders vorteilhaft ist, dass ein selbstleitender FET verwendet wird, der an vielen Stellen bei anderweitigem Einsatz aus Sicherheitsgründen nicht vorteilhaft wäre.

## Patentansprüche

1. Vorrichtung (1) zur Messung von Strom, aufweisend
- einen Feldeffekttransistor (10), der eine maximale Sperrspannung von höchstens 100 V und zwei Knotenpunkte (15, 16) aufweist zur seriellen Einbindung in einen Leiter (2), der den zu messenden Strom führt, wobei einer der Knotenpunkte (15, 16) mit dem Drain-Kontakt und ein weiterer der Knotenpunkte (15, 16) mit dem Source-Kontakt des Feldeffekttransistors (10) verbunden ist,
- eine parallel zum Feldeffekttransistor (10) angeordnete Einrichtung zur Messung der am Feldeffekttransistor (10) zwischen den Knotenpunkten (15, 16) abfallenden Spannung,
- eine Steuereinrichtung zur Ansteuerung des Gate-Kontakts des Feldeffekttransistors (10) und zur Wandlung des Signals der Einrichtung zur Messung der Spannung in einen Wert für den durch den Feldeffekttransistor (10) fließenden Strom.

2. Vorrichtung (1) nach Anspruch 1, bei der die Steuereinrichtung ausgestaltet ist, für eine Strommessung den Gatekontakt des Feldeffekttransistors (10) mit einer Steuerspannung zu beaufschlagen.

3. Vorrichtung (1) nach Anspruch 1 oder 2, bei der die Steuereinrichtung ausgestaltet ist, außerhalb von einer Strommessung den Gatekontakt des Feldeffekttransistors (10) spannungslos zu schalten.

4. Vorrichtung (1) nach einem der vorangehenden Ansprüche, bei der der Feldeffekttransistor (10) ein selbstleitender Feldeffekttransistor (10) ist.

5. Vorrichtung (1) nach einem der vorangehenden Ansprüche, bei der der Feldeffekttransistor (10) eine maximale Sperrspannung von höchstens 30 V aufweist.

6. Vorrichtung (1) nach einem der vorangehenden Ansprüche, bei der die Steuereinrichtung ausgestaltet ist, bei der Strommessung zu ermitteln, ob die von der Einrichtung zur Messung der Spannung ermittelte Spannung einen Schwellwert unterschreitet und in diesem Fall anstelle der Steuerspannung eine gegenüber der Steuerspannung erhöhte zweite Steuerspannung an den Gatekontakt anzulegen.

7. Vorrichtung (1) nach einem der vorangehenden Ansprüche, bei der die Steuereinrichtung ausgestaltet ist, bei der Strommessung zu ermitteln, ob die von der Einrichtung zur Messung der Spannung ermittelte Spannung einen Schwellwert unterschreitet und in diesem Fall anstelle der Steuerspannung eine gegenüber der Steuerspannung erhöhte zweite Steuerspannung an den Gatekontakt anzulegen.

8. Vorrichtung (1) nach einem der vorangehenden Ansprüche mit einer Temperaturmesseinrichtung zur Bestimmung der Temperatur des Feldeffekttransistors (10), wobei die Steuereinrichtung ausgestaltet ist, bei der Wandlung des Signals die Temperatur als Eingangswert zu berücksichtigen.

9. Vorrichtung (1) nach einem der vorangehenden Ansprüche, bei der die Steuereinrichtung ausgestaltet ist, einen Wert für den Strom anhand eines in einem Speicher hinterlegten Kennlinienfeldes zu ermitteln.

10. Vorrichtung (1) nach einem der vorangehenden Ansprüche, bei der parallel zum Feldeffekttransistor (10) ein elektrischer Widerstand geschaltet ist.

11. Elektrischer Wandler mit einer Mehrzahl von Anschlussknoten, wobei durch zwei der Anschlussknoten ein Laststrompfad gegeben ist, wobei der Wandler eine Vorrichtung (1) nach einem der vorangehenden Ansprüche umfasst, die seriell im Laststrompfad angeordnet ist.

12. Verfahren zur Messung von Strom, bei dem
- ein Feldeffekttransistor (10) mit einer maximalen Sperrspannung von höchstens 100 V, insbesondere höchstens 30 V, seriell mit dem Drain- und Source-Kontakt in einen Leiter (2), der den zu messenden Strom führt, eingebunden wird,
- die am Feldeffekttransistor (10) zwischen den Anschlusspunkten an den Leiter abfallende Spannung ermittelt wird,
- die ermittelte abfallende Spannung in einen Wert für den durch den Feldeffekttransistor (10) fließenden Strom gewandelt wird.

13. Verfahren nach Anspruch 12, bei der der Feldeffekttransistor (10) dediziert für die Messung von Strom verwendet wird.
